# EUROPEAN PATENT SPECIFICATION

(11) **EP 2 798 647 B1**
(45) Date of publication and mention of the grant of the patent: **20.07.2016**
(21) Application number: 12863656.0
(22) Date of filing: 26.12.2012
(51) Int. Cl.: H01B 1/04, H01B 1/24, H01B 5/14

(54) **TRANSPARENT ELECTRODE**
TRANSPARENTE ELEKTRODE
ELECTRODE TRANSPARENTE

(30) Priority: 30.12.2011 KR 20110147881
(43) Date of publication of application: 05.11.2014
(73) Proprietor: Kolon Industries, Inc., Gyeonggi-do 427-800 (KR)
(72) Inventor: SONG, Sang Min, Gyeonggi-do 461-741 (KR); JUNG, Hak Gee, Gyeonggi-do 448-172 (KR); PARK, Hyo Jun, Gyeonggi-do 448-160 (KR); KIM, Sang Kyun, Gyeonggi-do 446-913 (KR); KIM, Ye Seul, Incheonsi 403-023 (KR)
(74) Representative: Ter Meer Steinmeister & Partner
(86) International application number: PCT/KR2012/011451
(87) International publication number: WO 2013/100550

(56) References cited:
- WO-A1-2009/137508
- WO-A2-2007/094757
- WO-A2-2009/032614
- US-A1- 2008 286 559
- US-A1- 2009 252 967
- US-B2- 7 378 040
- DATABASE CA [Online] CHEMICAL ABSTRACTS SERVICE, COLUMBUS, OHIO, US; 21 August 2009 (2009-08-21), SOMEYA, TAKAO ET AL: "Carbon nanotube rubber compositions, their wirings, electrically conductive pastes, electronic circuits, and manufacture method", XP002739092, retrieved from STN Database accession no. 2009:1016753 -& WO 2009/102077 A1 (UNIV TOKYO [JP]; NAT INST OF ADVANCED IND SCIEN [JP]; SOMEYA TAKAO [JP) 20 August 2009 (2009-08-20)
- JANG ET AL: "The optical and dielectric characterization of light-colored fluorinated polyimides based on 1,3-bis(4-amino-2-trifluoromethylphenoxy)b enzene", MATERIALS CHEMISTRY AND PHYSICS, ELSEVIER SA, SWITZERLAND, TAIWAN, REPUBLIC OF CHINA, vol. 104, no. 2-3, 19 July 2007 (2007-07-19), pages 342-349, XP022157246, ISSN: 0254-0584, DOI: 10.1016/J.MATCHEMPHYS.2007.03.025

## Description

### Technical Field

The present invention relates to a transparent electrode, and, more particularly, to a transparent electrode in which an organic conductive layer is formed on a plastic substrate.

### Background Art

As computers, electrical household appliances and communication appliances are digitalized and their performance is rapidly increased, it is keenly required to realize large-size portable displays. Display materials which can be folded and rolled like a newspaper are required in order to realize portable large-area flexible displays.

Therefore, electrode materials for displays not only must be transparent and exhibit low resistance but also must exhibit high strength such that devices can be mechanically stabilized even when they are bent or folded. Further, electrode materials for displays must have a thermal expansion coefficient similar to that of a plastic substrate such that appliances do not short-circuit or experience great changes to their surface resistance even when they are overheated to high temperature.

Since flexible displays enable the manufacture of displays having various shapes, they can be used for logos on clothes, advertising boards, price list panels of goods display stands, large-area illumination apparatuses and the like, whose colors and patterns can be changed, as well as portable displays.

In relation to this, a transparent conductive thin film is widely used in devices requiring both transmissivity and conductivity, such as image sensors, solar cells, various types of displays (PDPs, LCDs, PDPs, etc.) and the like.

Indium tin oxide (ITO), which is used to make a transparent electrode for flexible displays, has been researched extensively. However, the indium tin oxide (ITO) is problematic in that high process costs are required because a vacuum process is needed to form an ITO thin film and in that the lifespan of a flexible display becomes short because the ITO thin film easily breaks when the flexible display is bent or folded.

In order to solve the above problems, Korean Unexamined Patent Application Publication No. 10-2005-001580 discloses a method of manufacturing a transparent electrode having a transmissivity of 80% or more and a surface resistance of 100 ohm/ sq or less in the visible light range, in which carbon nanotubes are dispersed in or on a coating layer on the nanoscale by chemically bonding carbon nanotubes with polymers and then forming the resulting product into a film or by coating a conductive polymer layer with purified carbon nanotubes or carbon nanotubes chemically bonded with polymers, and then metal nanoparticles, such as gold, silver or the like, are added to the carbon nanotube-dispersed coating layer, thus minimizing the scattering of light in the visible light range and improving conductivity. In this publication, specifically, the transparent electrode is manufactured by reacting a carbon nanotube-dispersed solution with polyethylene terephthalate (PET) to prepare a highly-concentrated carbon nanotube-polymer copolymer solution, applying the copolymer solution onto a polyester film and then drying the copolymer solution.

However, when the transparent electrode manufactured in this way is used at high temperature, polymer modification can occur.

Further, a bendable transparent electrode is obtained by coating a polymer substrate with a conductive layer including carbon nanotubes. When the conductive layer including carbon nanotubes is formed on the polymer substrate, there is a problem in that the adhesivity and environmental stability of the bendable transparent electrode deteriorate when carbon nanotubes are exposed to the outside.

### Disclosure of Invention

### Technical Problem

Accordingly, the present invention has been made to solve the above-mentioned problems, and an object of the present invention is to provide a transparent electrode in which a conductive layer including a conductive material containing carbon nanotubes and a polymer binder is formed on a plastic substrate, so carbon nanotubes strongly adhere to the plastic substrate, and the transparent electrode exhibits environmental stability.

### Solution to Problem

In order to accomplish the above object, an aspect of the present invention provides a transparent electrode, including: a colorless transparent polyimide film substrate; and a conductive layer formed on the substrate and including a conductive material containing carbon nanotubes, wherein the conductive layer includes a polymer binder selected from polycarbosilane, polysilane, polysiloxane, polysilazane and derivatives thereof.

In this case, the polymer binder may include a polymer or a polymer derivative substituted with a hydrogen atom or a substituent group selected from an alkyl group, an alkenyl group, a cycloalkyl group, an allyl group and an alkoxy group.

In the transparent electrode, the conductive material includes a mixture of carbon nanotubes and a conductive supplement,

wherein the conductive supplement includes a conductive polymer selected from polyacetylene, polypyrrole, polyaniline, polythiophene, derivatives thereof, and mixtures thereof.

In the transparent electrode, the conductive layer may be obtained by applying a solution including the polymer binder onto the polyimide film substrate including a conductive material film formed thereon.

In the transparent electrode, the conductive material film may be a carbon nanotube-conductive supplement composite film which is formed by applying a carbon nanotube-dispersed solution onto the polyimide film substrate to form a carbon nanotube-dispersed layer and then applying a solution including the conductive supplement onto the carbon nanotube-dispersed layer.

Further, the conductive material film may be a carbon nanotube-conductive supplement composite film which is formed by applying a mixed solution of a carbon nanotube-dispersed solution and a solution including the conductive supplement onto the polyimide film substrate.

In the transparent electrode, the carbon nanotubes may be selected from single-walled carbon nanotubes, double-walled carbon nanotubes, and multi-walled carbon nanotubes.

The transparent electrode may have a transmittance of 70% or more and a surface resistance of 1000 ohm/sq or less when it further includes a plastic substrate.

Further, the transparent electrode may have a transmittance of 70% or more at a wavelength of 550 nm and a surface resistance of 1000 ohm/sq or less.

### Advantageous Effects of Invention

According to the transparent electrode of the present invention, a conductive layer including a conductive material containing carbon nanotubes and a polymer binder is formed on a plastic substrate, so carbon nanotubes strongly adhere to the plastic substrate, and the transparent electrode exhibits environmental stability.

### Best Mode for Carrying out the Invention

Hereinafter, the present invention will be described in detail.

The transparent electrode of the present invention includes a colorless transparent polyimide film substrate. Hereinafter, the colorless transparent polyimide film substrate will be understood as a colorless transparent film which has heat resistance that is an intrinsic property of a polyimide resin and which does not exhibit yellowness that is an intrinsic property of a polyimide film.

A colorless transparent polyimide film having high heat resistance can be usefully used as a substrate of the transparent electrode of the present invention without limitation. For example, there is a polyimide film having an average linear thermal expansion coefficient (CTE) of 50.0 ppm/°C or less, which was measured at a temperature range of 50 to 250°C by thermomechanical analysis under the condition of a film thickness of 50 ∼ 100 *µ*m, a yellowness of 15 or less and a transmittance of 80% or more at a wavelength of 550 nm, which was measured by a UV spectrometer. In this case, when the average linear thermal expansion coefficient (CTE) of the polyimide film is more than 50.0 ppm/°C, the difference in thermal expansion coefficient between the polyimide film and a plastic substrate increases, so there are problems of appliances overheating or a short circuit occurring at high temperature. When the yellowness of the polyimide film is more than 15, its transparency deteriorates, so it cannot be suitably used to manufacture a transparent electrode. Here, the average linear thermal expansion coefficient (CTE) of the polyimide film is obtained by measuring the deformation modulus of the polyimide film according to temperature increase within the predetermined temperature range, and the deformation modulus thereof may be measured by a thermomechanical analyzer. It is preferred that the average linear thermal expansion coefficient (CTE) thereof be 35.0 ppm/°C or less. When such a polyimide film is used, a heat-resistant transparent electrode, whose fusion temperature is higher than that of a plastic substrate made of polyethylene terephthalate (PET), polyether sulfone (PES), polycarbonate (PC) or the like, can be formed.

The polyimide film satisfying such conditions may be obtained from a resin including: a unit structure derived from one or more aromatic dianhydrides selected from the group consisting of 2,2-bis(3,4-dicarboxyphenyl)hexafluoropropane dianhydride (FDA), 9,9-bis(trifluoromethyl)-2,3,6,7-xanthene tetracarboxylic dianhydride (6FCDA), 4-(2,5-dioxotetrahydrofuran-3-yl)-1,2,3,4-tetrahydronaphthalene-1,2-dicarboxylic anhydride (TDA), and 4,4'-(4,4'-isopropylidenediphenoxy)bis(phthalic anhydride)(HBDA); a unit structure derived from one or more selected from the group consisting of pyromellitic dianhydride (PMDA), biphenyltetracarboxylic dianhydride (BPDA), and oxydiphthalic dianhydride (ODPA); and a unit structure derived from one or more aromatic diamines selected from the group consisting of 2,2-bits [4-(4-aminophenoxy)-phenyl]propane (6HMDA), 2,2'-bis(trifluoromethyl)-4,4'-diaminobiphenyl (2,2'-TFDB), 3,3'-bis(trifluoromethyl)-4,4'-diaminobiphenyl (3,3'-TFDB), 4,4'-bis(3-aminophenoxy)diphenylsulfone (DBSDA), bis(3-aminophenyl)sulfone (3DDS), bis(4-aminophenyl)sulfone (4DDS), 1,3-bis(3-aminophenoxy)benzene (APB-133), 1,4-bis(4-aminophenoxy)benzene (APB-134), 2,2'-bis[3(3-aminophenoxy)phenyl]hexafluoropropane (3-BDAF), 2,2'-bis[4(4-aminophenoxy)phenyl]hexafluoropropane (4-BDAF), 2,2'-bis(3-aminophenyl)hexafluoropropane (3,3'-6F), 2,2'-bis(4-aminophenyl)hexafluoropropane (4,4'-6F), and oxydianiline (ODA). Further, the polyimide film may be obtained from a resin including: a unit structure derived from the aromatic dianhydrides; a unit structure derived from one or more aromatic dicarbonyl compounds selected from the group consisting of p-Terephthaloyl chloride (TPC), terephthalic acid, iso-phthaloyl dichloride, and 4,4'-benzoyl chloride; and a unit structure derived from the aromatic diamines.

A conductive layer is formed on such a polyimide film substrate. The conductive layer includes a conductive material containing carbon nanotubes, and includes a polymer binder selected from polycarbosilane, polysilane, polysiloxane, polysilazane and derivatives thereof. In this case, the polymer binder serves to improve the adhesivity and environmental stability of the conductive layer.

Here, the conductive material may includes a mixture of carbon nanotubes and a conductive supplement.

The carbon nanotubes may be selected from single-walled carbon nanotubes, double-walled carbon nanotubes, and multi-walled carbon nanotubes. The selected carbon nanotube may be an acid-treated carbon nanotube whose surface is provided with a functional group.

The conductive supplement included in the conductive layer is a conductive polymer selected from polyacetylene, polypyrrole, polyaniline, polythiophene, derivatives thereof, and mixtures thereof. A working for replenishing the reduced electroconductivity of a transparent electrode may be additionally required according to the use of the transparent electrode. In this case, when the transparent electrode further includes the conductive supplement, the reduced electroconductivity of the transparent electrode can be replenished.

The polymer binder is an organic-inorganic hybrid polymer, and exhibits high heat resistance. Thanks to the high resistance of the polymer binder, a transparent electrode having high heat resistance can be obtained by the synergistic action of the polymer binder and the above-mentioned colorless transparent polyimide film. The polymer binder selected from polycarbosilane, polysilane, polysiloxane, polysilazane and derivatives thereof may be substituted with a hydrogen atom or a substituent group selected from an alkyl group, an alkenyl group, a cycloalkyl group, an allyl group and an alkoxy group.

As described above, the conductive layer includes a conductive material containing carbon nanotubes and a heat-resistant polymer binder. The technologies for forming the conductive layer include a technology for coating a substrate with carbon nanotubes to form a carbon nanotube layer and then coating the carbon nanotube layer with a binder and a technology for coating a substrate with a carbon nanotube-dispersed solution including a binder and a dispersant.

In the latter case, a binder and a dispersant are additionally used, and the polymer resin and dispersant are different from each other in carbon nanotube dispersing characteristics according to the kind thereof. Therefore, suitable dispersion conditions, such as the selection of a dispersant, etc., must be provided according to the kind of a polymer resin.

Further, additional additives, such as a binder and the like, are needed in order to strongly attach a carbon nanotube layer to a substrate. In this case, when the carbon nanotube layer includes a binder, adhesivity and environmental stability are improved, but the electroconductivity of a transparent electrode including carbon nanotubes can be deteriorated because the binder is an insulator.

Generally, a polymer binder can be usefully used to improve the adhesivity and environmental stability of a carbon nanotube layer, but can deteriorate the electroconductivity of the carbon nanotube layer when the polymer binder is an insulation material. A working for replenishing the reduced electroconductivity of a transparent electrode may be additionally required according to the use of the transparent electrode. When a conductive supplement is added in order to improve the electroconductivity of a transparent electrode, a conductive supplement is applied onto a carbon nanotube layer, and then the carbon nanotube layer is coated with a polymer binder. Further, a conductive supplement is added to a carbon nanotube-dispersed solution to prepare a carbon nanotube-conductive supplement composite solution, and then a substrate is coated with the carbon nanotube-conductive supplement composite solution to form a conductive material layer on the substrate. The conductive material layer is coated with a polymer binder to form a conductive layer.

Preferably, the conductive layer may be obtained by applying a solution including a polymer binder onto a polyimide film substrate including a conductive material film formed thereon.

More specifically, the conductive material film, which is a carbon nanotube-conductive supplement composite film, is formed by applying a carbon nanotube-dispersed solution onto the polyimide film substrate to form a carbon nanotube-dispersed layer and then applying a solution including the conductive supplement onto the carbon nanotube-dispersed layer. The conductive material film is coated with a solution including a polymer binder to form a conductive layer.

Further, the conductive material film, which is a carbon nanotube-conductive supplement composite film, is formed by applying a mixed solution of a carbon nanotube-dispersed solution and a solution including the conductive supplement onto the polyimide film substrate. The conductive material film is coated with a solution including a polymer binder to form a conductive layer.

The carbon nanotube-dispersed solution may be prepared using a 3-roll mill, a sonicator, a homogenizer, a ball mill or the like. In order to improve the adhesivity and environmental stability of the conductive layer, the carbon nanotube layer may be coated with a polymer binder.

The structure of the conductive layer of the transparent electrode of the present invention is described in detail as follows. When a carbon nanotube-containing electrode material film (hereinafter, referred to as "a carbon nanotube layer") is formed on a polyimide film substrate, carbon nanotubes are irregularly arranged and laminated to have a reticular structure. Therefore, a space in which carbon nanotubes are not occupied is formed in the carbon nanotube layer. When the upper surface of the carbon nanotube layer is coated with a polymer binder solution, the space between carbon nanotubes is charged with the polymer binder solution. In this case, when the carbon nanotube layer coated with the polymer binder solution is dried and cured, a conductive layer having adhesivity and environmental stability to a substrate can be formed.

Coating methods for forming a conductive layer are not particularly limited. Examples of the coating methods may include, but are not limited to, spray coating, bar coating, dip coating, spin coating, gravure coating, roll coating, and impregnation.

It is preferred that the thickness of the conductive layer be 0.01 ∼ 0.5 *µ*m, considering the adhesivity and surface resistance characteristics attributable to a polymer binder and transmittance and flexibility characteristics.

The transparent electrode manufactured in this way may have a transmittance of 70% or more and a surface resistance of 1000 ohm/sq or less when it further includes a plastic substrate.

### Mode for the Invention

Hereinafter, the present invention will be described in more detail with reference to the following Examples. However, the scope of the present invention is not limited thereto.

### Preparation of polyimide film substrate

### <Preparation Example 1>

28.78 g of N,N-dimethylacetamide (DMAc) was charged in a 100 mL 3-neck roundbottom flask, as a reactor, provided with a stirrer, a nitrogen injector, a dropping funnel, a temperature controller and a cooler while passing nitrogen through the flask, and then the reactor is cooled to 0°C, and then 3.2023 g (0.01 mol) of 2,2'-TFDB was dissolved in the N,N-dimethylacetamide (DMAc) to form a first solution, and then the first solution was maintained at 0°C. Subsequently, 0.88266 g (0.003 mol) of BPDA was added to the first solution to form a second solution, and then the second solution was stirred for 1 hour to completely dissolve BPDA in the second solution. In this case, the concentration of solid matter in the second solution was 20 wt%. Thereafter, this second solution was stirred for 8 hours at room temperature to obtain a polyamic acid solution having a viscosity of 2100 poise at 23°C.

Subsequently, 2 ∼ 4 equivalents of acetic anhydride (manufactured by Samchun Chemical Co., Ltd.) as a curing agent and 2 ∼ 4 equivalents of pyridine (manufactured by Samchun Chemical Co., Ltd.) were added to the polyamic acid solution, and then the polyamic acid solution was heated to 20 ∼ 180°C for 1 ∼ 10 hours at a heating rate of 10 °C/min to imidize the polyamic acid solution. Subsequently, 30 g of the imidized polyamic acid solution was mixed with 300 g of water or a nonpolar solvent (methanol, ethanol or the like) to precipitate the imidized polyamic acid solution to obtain solid matter. Then, the obtained solid matter was filtered, pulverized and then dried in a vacuum oven at 80 ∼ 100°C for 6 hours to obtain about 8 g of solid polyimide resin powder. Subsequently, the obtained solid polyimide resin powder was dissolved in 32 g of at least one solvent selected from DMAc, DMF, NMP, GBL (gamma-butyrolactone) and BC (butylcellulose) to obtain 20 wt% of a polyimide resin solution. The obtained polyimide resin solution was heated to 40 - 400°C for 1 ∼ 8 hours at a heating rate of 10°C/min by a film forming process to obtain a polyimide film having a thickness of 50 µm (the polyimide film has an average linear thermal expansion coefficient (CTE) of 19.22 ppm/°C or less, which was measured at a temperature range of 50 to 250°C by thermomechanical analysis under the condition of a film thickness of 50 - 100 *µ*m, has a yellowness of 2.86 or less and has a transmittance of 88.41% at a wavelength of 550 nm, which was measured by a UV spectrometer).

### Example 1

Carbon nanotubes (single-walled carbon nanotubes, manufactured by Nanosolution Corporation) were mixed with an aqueous solution including 1 wt% of sodium dodecyl sulfate to a concentration of 1 mg/mL, and then dispersed for 1 hour using a sonicator to obtain a dispersion solution. Then, conglomerated carbon nanotubes were separated from the obtained dispersion solution using a centrifugal separator to obtain a carbon nanotube-dispersed solution having high dispersivity.

The obtained carbon nanotube-dispersed solution was sprayed onto the surface of a polyimide film substrate, and was then dried at 80°C to form a carbon nanotube-dispersed layer. The carbon nanotube-dispersed layer was sufficiently washed with distilled water to remove sodium dodecyl sulfate therefrom.

Subsequently, the washed carbon nanotube-dispersed layer was bar-coated with a conductive supplement solution having a solid content of 1 wt% in methanol, that is, a PEDOT (poly(3,4-ethylenedioxythiophene))-acrylic resin solution (content of PEDOT in solid matter: 50 wt%).

Thereafter, the carbon nanotube-dispersed layer bar-coated with the conductive supplement solution was dried at 80°C for 2 minutes, and was then cured at 120°C for 10 minutes to form a conductive material film which is a carbon nanotube-conductive polymer layer.

Subsequently, the conductive material film was bar-coated with a solution of polysilazane (polymer binder) and methylethylketone having a solid content of 5 wt%. Then, the bar-coated conductive material film was dried at 120°C, and was then treated at a temperature of 80°C and a relative humidity of 95% for 3 hours to form a polymer resin film, thereby obtaining a transparent electrode including a polyimide film substrate and a conductive layer formed on the polyimide film substrate.

### Example 2

A transparent electrode was manufactured in the same manner as in Example 1, except that a carbon nanotube-dispersed layer was directly bar-coated with a polymer binder solution without including a process of introducing a conductive supplement into a polymer substrate coated with carbon nanotubes.

### Example 3

A transparent electrode was manufactured in the same manner as in Example 1, except that, when a conductive supplement was introduced, a polymer substrate coated with a carbon nanotube layer was dip-coated with a conductive supplement solution. At the time of the dip coating, a protective film was attached to the rear surface of a conductive layer of a substrate to prevent the conductive supplement from adhering thereto. Here, this dip coating process was carried out at a dip coating rate of 10 mm/ min.

### Example 4

Single-walled carbon nanotubes surface-functionalized by acid treatment were mixed with methanol to a concentration of 1 mg/mL, and were then dispersed for 1 hour using a sonicator to obtain a carbon nanotube-dispersed solution.

Subsequently, the obtained carbon nanotube-dispersed solution was mixed with a conductive supplement solution having a solid content of 1 wt% in methanol, that is, a PEDOT (poly(3,4-ethylenedioxythiophene))-acrylic resin solution (content of PEDOT in solid matter: 50 wt%) such that the weight of a conductive polymer (PEDOT) compared to carbon nanotubes was 5 times as much, and was then stirred for 30 minutes to obtain a carbon nanotube-conductive supplement mixed solution.

Thereafter, the obtained carbon nanotube-conductive supplement mixed solution was applied onto the surface of a polyimide film substrate by bar coating, and was then dried at 80°C to form a conductive material film.

Subsequently, the conductive material film was bar-coated with a solution of polysilazane and methylethylketone having a solid content of 5 wt%.

Then, the bar-coated conductive material film was dried at 120°C, and was then treated at a temperature of 80°C and a relative humidity of 95% for 3 hours to form a polymer resin film, thereby obtaining a transparent electrode including a polyimide film substrate and a conductive layer formed on the polyimide film substrate.

### Example 5

A transparent electrode was manufactured in the same manner as in Example 4, except that the polyimide film substrate was spray-coated with the carbon nanotube-conductive supplement mixed solution instead of the polyimide film substrate being bar-coated with the carbon nanotube-conductive supplement mixed solution.

### Comparative Example 1

A transparent electrode was manufactured in the same manner as in Example 1, except that a polyethylene terephthalate film was used as a substrate.

### Comparative Example 2

A transparent electrode was manufactured in the same manner as in Example 2, except that a polyethylene terephthalate film was used as a substrate.

### Comparative Example 3

A transparent electrode was manufactured in the same manner as in Example 4, except that a polyethylene terephthalate film was used as a substrate.

The physical properties of the transparent electrodes obtained from the Examples 1 to 5 and Comparative Examples 1 to 3 were evaluated as follow, and the results thereof are given in Table 1 below.

### (1) Optical properties

The visible light transmittance of each of the prepared transparent electrodes was measured using a UV spectrometer (Cary100, manufactured by Varian Co., Ltd.).

### (2) Surface resistance

The surface resistance values thereof were measured ten times using a high resistance meter (Hiresta-UP MCT-HT450, manufactured by Mitsubishi Chemical Corp.) having a measuring range of 10×10⁵ ∼ 10×10¹⁵ and a low resistance meter (CMT-SR 2000N, manufactured by Advanced Instrument Technology (AIT) Corp., 4- Point Probe System) having a measuring range of 10×10⁻³ ∼ 10×10⁵, and then the average value of the measured surface resistance values was obtained. The surface resistance uniformity was calculated using the standard deviation of the surface resistance values measured ten times.

### (3) Adhesivity evaluation

The adhesivity between a conductive layer and a polymer substrate was measured using a tape method (ASTM D 3359-02). Specifically, the polymer substrate coated with the conductive layer was divided (5x5) into 25 regions, and then tape was airtightly attached to the divided polymer substrate, and then the tape was detached from the polymer substrate at the same time. Thereafter, the surface resistance in each of the regions was measured. In this case, when the percentage of the regions in which surface resistance was changed was 0%, it was designated as 5B, when the percentage thereof was 5% or less, it was designated as 4B, when the percentage thereof was 5 ∼ 15%, it was designated as 3B, when the percentage thereof was 15 ∼ 35%, it was designated as 2B, when the percentage thereof was 35 ∼ 65%, it was designated as 1B, when the percentage thereof was 65% or more, it was designated as 0B.

### (4) Heat resistance evaluation

The heat resistance of a transparent electrode was evaluated by measuring the transmittance and surface resistance of the transparent electrode after storing the transparent electrode at 180°C for 1 hour.

Table 1

**[Table 1]**

| | Total thickness of conductive layer (m) | Transmittance (550 nm, %) | Surface resistance (ohm/sq.) | Resistance uniformity (%) | Adhesion test | After heat resistance evaluation | |
|---|---|---|---|---|---|---|---|
| | | | | | | Transmittance (550 nm, %) | Surface resistance (ohm/sq.) |
| Ex. 1 | 0.2 | 85.5 | 281 | 5% | 5B | 85.5 | 294 |
| Ex. 2 | 0.18 | 85.7 | 430 | 2% | 5B | 85.6 | 428 |
| Ex. 3 | 0.2 | 85.5 | 294 | 7% | 5B | 85.5 | 300 |
| Ex. 4 | 0.2 | 85.4 | 275 | 5% | 5B | 85.4 | 279 |
| Ex. 5 | 0.2 | 85.5 | 277 | 6% | 5B | 85.4 | 275 |
| Comp. Ex. 1 | 0.2 | 85.6 | 293 | 6% | 5B | - | - |
| Comp. Ex. 2 | 0.18 | 85.7 | 420 | 4% | 5B | - | - |
| Comp. Ex. 3 | 0.2 | 85.4 | 310 | 7% | 5B | - | - |

Hereinafter, the physical properties and applicability of the transparent electrodes manufactured by the methods of Examples 1 to 5 will be proposed.

The transparent electrodes manufactured by the methods of Examples 1 to 5 can be used as transparent electrodes for touch panels and displays and transparent electrodes requiring electrical conductivity and optical transparency, and can be used in various fields according to use thereof. For this reason, the transparent electrode of Example 2 exhibits high surface resistance to transmittance compared to the transparent electrodes of Example 1 and 3 to 5 because its conductive layer does not include a conductive supplement, but exhibit suitable physical properties (transmittance: 85% or more, surface resistance: 500 ohm/sq or less) to such a degree that it can be used as a transparent electrode for a resistive touch panel.

Further, for example, in order to realize a transparent electrode provided with an LCD drive layer, in the process of forming an oriented film, heat treatment must be carried out at 180°C for 1 hour. Therefore, the evaluation of heat resistance of the transparent electrode was performed according to the above-mentioned conditions. In Comparative Examples 1 to 3, since a polyethylene terephthalate film was used as a substrate, the outer appearances of the transparent electrodes manufactured according to the heat resistance evaluation conditions were deformed, and thus the physical properties thereof were not able to be measured. In contrast, in Examples 1 to 5, the outer appearances of the transparent electrodes thereof were not deformed, and, as given in Table 1, the changes in transmittance and surface resistance thereof is present within the range of 10%.

From the results of Table 1 above, it can be inferred that each of the transparent electrodes of Examples 1 to 5 has a conductive layer including a polymer binder, and thus a conductive material strongly adheres to a substrate.

Three kinds of reliability evaluations of the transparent electrodes obtained from Examples 1 to 5 and Comparative Examples 1 to 3 were performed under the following conditions. The results thereof are given in Table 2 below.
- Heat resistance evaluation: 80°C, 240 h
- Impact resistance evaluation: -30°C ∼ 85°C, 10 times
- Weather resistance evaluation: 60°C, 5%RH, 240 h

Table 2

**[Table 2]**

| | Before evaluation | | Heat resistance evaluation | | Impact resistance evaluation | | Weather resistance evaluation | |
|---|---|---|---|---|---|---|---|---|
| | Transmittance (550 nm, %) | Surface resistan ce (ohm/s q.) | Transmittance (550 nm, %) | Surface resistance (ohm/sq. ) | Transmittance (550 nm, %) | Surface resistance (ohm /sq.) | Transmittance (550 nm, %) | Surface resistance (ohm / sq.) |
| Ex. 1 | 85.5 | 281 | 85.4 | 283 | 85.6 | 280 | 85.5 | 291 |
| Ex. 2 | 85.7 | 430 | 85.5 | 424 | 85.6 | 425 | 85.6 | 441 |
| Ex. 3 | 85.5 | 294 | 85.4 | 299 | 85.4 | 300 | 85.5 | 302 |
| Ex. 4 | 85.4 | 275 | 85.6 | 275 | 85.4 | 281 | 85.3 | 279 |
| Ex. 5 | 85.5 | 277 | 85.3 | 274 | 85.5 | 283 | 85.4 | 281 |
| Comp. Ex. 1 | 85.6 | 293 | 85.5 | 302 | 85.6 | 295 | 85.6 | 298 |
| Comp. Ex. 2 | 85.7 | 420 | 85.6 | 424 | 85.6 | 431 | 85.8 | 429 |
| Comp. Ex. 3 | 85.4 | 310 | 85.2 | 314 | 85.3 | 311 | 83.4 | 316 |

From the results of Table 2 above, it can be ascertained that the transparent electrodes of Examples 1 to 5 have excellent environmental stability satisfying the surface resistance change rate of 10% or less because each of them has a conductive layer including a polymer binder having excellent heat resistance.

## Claims

1. A transparent electrode, comprising:
a colorless transparent polyimide film substrate; and
a conductive layer formed on the substrate and including a conductive material containing a mixture of carbon nanotubes and a conductive supplement,
wherein the conductive layer includes a polymer binder selected from polycarbosilane, polysilane, polysiloxane, polysilazane and derivatives thereof,
wherein the conductive supplement includes a conductive polymer selected from polyacetylene, polypyrrole, polyaniline, polythiophene, derivatives thereof, and mixtures thereof.

2. The transparent electrode of claim 1, wherein the conductive layer is obtained by applying a solution including the polymer binder onto the polyimide film substrate including a conductive material film formed thereon.

3. The transparent electrode of claim 2, wherein the conductive material film is a carbon nanotube-conductive supplement composite film which is formed by applying a carbon nanotube-dispersed solution onto the polyimide film substrate to form a carbon nanotube-dispersed layer and then applying a solution including the conductive supplement onto the carbon nanotube-dispersed layer.

4. The transparent electrode of claim 2, wherein the conductive material film is a carbon nanotube-conductive supplement composite film which is formed by applying a mixed solution of a carbon nanotube-dispersed solution and a solution including the conductive supplement onto the polyimide film substrate.

5. The transparent electrode of claim 1, wherein the carbon nanotubes are selected from single-walled carbon nanotubes, double-walled carbon nanotubes, and multi-walled carbon nanotubes.

6. The transparent electrode of claim 1, wherein the polymer binder includes a polymer or a polymer derivative substituted with a hydrogen atom or a substituent group selected from an alkyl group, an alkenyl group, a cycloalkyl group, an allyl group and an alkoxy group.

7. The transparent electrode of claim 1, wherein the transparent electrode has a transmittance of 70% or more at a wavelength of 550 nm measured using a UV spectrometer (Cary100, manufactured by Varian Co., Ltd.)and a surface resistance of 1000 ohm/sq or less measured by the following method:
<Surface resistance>
The surface resistance values thereof were measured ten times using a high resistance meter (Hiresta-UP MCT-HT450, manufactured by Mitsubishi Chemical Corp.) having a measuring range of 10×10⁵ ∼ 10×10⁵ and a low resistance meter (CMT-SR 2000N, manufactured by Advanced Instrument Technology (AIT) Corp., 4- Point Probe System) having a measuring range of 10×10⁻³ ∼ 10×10⁵, and then the average value of the measured surface resistance values was obtained.

## Patentansprüche

1. Eine transparente Elektrode umfassend
ein farbloses transparentes Polyimid-Filmsubstrat; und
eine leitfähige Schicht, die auf dem Substrat ausgebildet ist und ein leitfähiges Material beinhaltet, das eine Mischung aus Kohlenstoff-Nanotubes und einem leitfähigen Zusatz enthält,
wobei die leitfähige Schicht ein polymeres Bindemittel ausgewählt aus Polycarbosilan, Polysilan, Polysiloxan, Polysilazan und deren Derivaten enthält,
wobei der leitfähige Zusatz ein leitfähiges Polymer ausgewählt aus Polyacetylen, Polypyrrol, Polyanilin, Polythiophen, deren Derivaten und Mischungen davon enthält.

2. Die transparente Elektrode gemäß Anspruch 1, wobei die leitfähige Schicht dadurch erhalten wird, dass eine Lösung, die das polymere Bindemittel enthält, auf das Polyimid-Filmsubstrat, das einen darauf ausgebildeten Film aus leitfähigem Material enthält, aufgebracht wird.

3. Die transparente Elektrode gemäß Anspruch 2, wobei der Film aus leitfähigem Material
ein Film aus einer Verbundstruktur aus Kohlenstoff-Nanotubes und dem leitfähigem Zusatz ist, der dadurch ausgebildet wird, dass eine Dispersionslösung mit Kohlenstoff-Nanotubes auf das Polyimid-Filmsubstrat aufgebracht wird, um eine Schicht mit dispergierten Kohlenstoff-Nanotubes auszubilden, und dass dann eine Lösung, die den leitfähigen Zusatz enthält, auf die Schicht mit dispergierten Kohlenstoff-Nanotubes aufgebracht wird.

4. Die transparente Elektrode gemäß Anspruch 2, wobei der Film aus leitfähigem Material
ein Film aus einem Verbundmaterial aus Kohlenstoff-Nanotubes und dem leitfähigem Zusatz ist, der dadurch ausgebildet wird, dass eine gemischte Lösung aus einer Lösung mit dispergierten Kohlenstoff-Nanotubes und einer Lösung, die das leitfähige Material beinhaltet, auf das Polyimid-Filmsubstrat aufgebracht wird.

5. Die transparente Elektrode gemäß Anspruch 1, wobei die Kohlenstoff-Nanotubes ausgewählt sind aus Kohlenstoff-Nanotubes mit einer Wand, Kohlenstoff-Nanotubes mit zwei Wänden und Kohlenstoff-Nanotubes mit vielen Wänden.

6. Die transparente Elektrode gemäß Anspruch 1, wobei das polymere Bindemittel ein Polymer oder ein polymeres Derivat enthält, das mit einem Wasserstoffatom oder einer Substituentengruppe, ausgewählt aus einer Alkylgruppe, einer Alkenylgruppe, einer Cycloalkylgruppe, einer Allylgruppe und einer Alkoxygruppe, substituiert ist.

7. Die transparente Elektrode gemäß Anspruch 1, wobei die transparente Elektrode eine Transmission von 70 % oder mehr bei einer Wellenlänge von 550 nm, gemessen mit einem UV-Spektrometer (Cary100, hergestellt von Varian Co., Ltd.), und einen Oberflächenwiderstand von 1000 Ohm/qm oder weniger, gemessen nach folgender Methode, aufweist:
<Oberflächenwiderstand>
Die Werte des Oberflächenwiderstands davon wurden zehnmal mit einem Hochohmwiderstands-Zähler (Hiresta-UP MCT-HT450, hergestellt von Mitsubishi Chemical Corp.) mit einem Messbereich von 10x10⁵ ∼ 10x10¹⁵ und einem Niedrigohmwiderstands-Zähler (CMT-SR 2000N, hergestellt von Advanced Instrument Technology (AIT) Corp., 4-Point Probe4 System) mit einem Messbereich von 10x10⁻³ ∼ 10x10⁵ gemessen und dann wurde der Durchschnittswert der gemessenen Werte des Oberflächenwiderstands ermittelt.

## Revendications

1. Une électrode transparente, comprenant:
un substrat de film de polyimide transparent incolore; et
une couche conductrice formée sur le substrat et comprenant un matériau conducteur contenant un mélange de nanotubes de carbone et d'un supplément conducteur, dans lequel la couche conductrice comprend un liant polymère choisi parmi le polycarbosilane, le polysilane, le polysiloxane, le polysilazane et les dérivés de ceux-ci,
dans lequel le supplément conducteur comprend un polymère conducteur choisi parmi le polyacétylène, le polypyrrole, la polyaniline, le polythiophène, leurs dérivés et leurs mélanges.

2. L'électrode transparente selon la revendication 1, dans laquelle la couche conductrice est obtenue en appliquant une solution comprenant le liant polymère sur le substrat de film de polyimide comprenant un film de matériau conducteur formé sur celui-ci.

3. L'électrode transparente selon la revendication 2, dans laquelle le film de matériau conducteur est un film composite de complément conducteur-nanotubes de carbone qui est formé en appliquant une solution de nanotubes de carbone dispersés sur le substrat de film de polyimide afin de former une couche de nanotubes de carbone dispersés, et en appliquant ensuite une solution comprenant le supplément conducteur sur la couche de nanotubes de carbone dispersés.

4. L'électrode transparente selon la revendication 2, dans laquelle le film de matériau conducteur est un film composite de complément conducteur-nanotubes de carbone, qui est formé en appliquant une solution mixte d'une solution de nanotubes de carbone dispersés et d'une solution comprenant le supplément conducteur sur le substrat de film de polyimide.

5. L'électrode transparente selon la revendication 1, dans laquelle les nanotubes de carbone sont choisis parmi des nanotubes de carbone à paroi unique, des nanotubes de carbone à double paroi, et des nanotubes de carbone à multi-parois.

6. L'électrode transparente selon la revendication 1, dans laquelle le liant polymère comprend un polymère ou un dérivé de polymère substitué par un atome d'hydrogène ou un groupe substituant choisi parmi un groupe alkyle, un groupe alcényle, un groupe cycloalkyle, un groupe allyle et un groupe alcoxy.

7. L'électrode transparente selon la revendication 1, dans laquelle l'électrode transparente a une transmittance de 70% ou plus à une longueur d'onde de 550 nm mesurée en utilisant un spectromètre UV (Cary100, fabriqué par Varian Co., Ltd.), et une résistance de surface de 1000 ohms / carré ou moins mesurée par le procédé suivant :
< résistance de surface >
les valeurs de résistance de surface ont été mesurés dix fois en utilisant un appareil de mesure de résistance élevée (Hiresta-UP TCM-HT450, fabriqué par Mitsubishi Chemical Corp.) ayant une plage de mesure de 10 x 105 ∼ 10 x 1015 et un appareil de mesure de résistance faible (CMT-SR 2000N, fabriqué par Advanced Instrument Technology (AIT) Corp., système d'échantillon à 4 points) ayant une plage de mesure de 10 x 10⁻³ ∼ 10 x 10⁵, et puis la valeur moyenne des valeurs de résistance de surface mesurées à été obtenue.
